# EUROPEAN PATENT APPLICATION

(11) **EP 2 733 748 A1**
(43) Date of publication of application: **21.05.2014**
(21) Application number: 13193434.1
(22) Date of filing: 19.11.2013
(51) Int. Cl.: H01L 31/0224, H01L 31/032

(54) **Photoelectric conversion element and solar cell**

(30) Priority: 20.11.2012 JP 2012254436
(71) Applicant: Kabushiki Kaisha Toshiba, Tokyo 105-8001 (JP)
(72) Inventor: Hiraga, Hiroki, Tokyo, 105-8001 (JP); Shibasaki, Soichiro, Tokyo, 105-8001 (JP); Nakagawa, Naoyuki, Tokyo, 105-8001 (JP); Yamazaki, Mutsuki, Tokyo, 105-8001 (JP); Yamamoto, Kazushige, Tokyo, 105-8001 (JP); Sakurada, Shinya, Tokyo, 105-8001 (JP); Inaba, Michihiko, Tokyo, 105-8001 (JP)
(74) Representative: HOFFMANN EITLE

(57) **Abstract**

A photoelectric conversion element (100) of the invention includes: a p-type light absorbing layer having a chalcopyrite structure (3); an n-type semiconductor layer (4) on the p-type light absorbing layer; an oxide layer (5) on the n-type semiconductor layer; and a transparent electrode (6) on the oxide layer.

## Description

### CROSS-REFERENCE TO RELATED APPLICATION

This application is based upon and claims the benefit of priority from Japanese Patent Applications No. 2012-254436 November 20, 2012; the entire contents of which are incorporated herein by reference.

### FIELD

Embodiments described herein relate generally to a photoelectric conversion element and a solar cell.

### BACKGROUND

Compound photoelectric conversion elements having a semiconductor thin film as a light absorbing layer have been developed. In particular, thin-film photoelectric conversion elements having, as a light absorbing layer, a p-type semiconductor layer with a chalcopyrite structure have high conversion efficiency and thus promising applications. Specifically, thin-film photoelectric conversion elements having a light absorbing layer of Cu(In,Ga)Se₂ as a Cu-In-Ga-Se compound have relatively high conversion efficiency.

A thin-film photoelectric conversion element has a p-type semiconductor layer of Cu-In-Ge-Se as a light absorbing layer. Such a thin-film photoelectric conversion element generally has a structure including a blue sheet glass substrate, and a molybdenum lower electrode, a p-type semiconductor layer, an n-type semiconductor layer, an insulating layer, a transparent electrode, an upper electrode, and an anti-reflection film, which are stacked on the substrate. The conversion efficiency η is expressed by η = Voc·Jsc·FF/P·100, wherein Voc is open circuit voltage, Jsc is short-circuit current density, FF is power factor, and P is incident power density. This shows that the conversion efficiency increases as the open circuit voltage, the short-circuit current, and the power factor increase, respectively. Theoretically, as the band gap between the light absorbing layer and the n-type semiconductor layer increases, the open circuit voltage increases, whereas the short-circuit current density decreases. When the efficiency change is observed as a function of band gap, a maximum exists at about 1.4 to 1.5 eV. It is known that the band gap of Cu(In,Ga)Se₂ increases with Ga concentration and that a photoelectric conversion element with high conversion efficiency can be obtained when Ga/(In + Ga) is controlled between about 0.4 and about 0.8.

The transparent electrode is formed on the n-layer using vapor deposition, sputtering, or metal organic chemical vapor deposition (MOCVD). This process can damage the n-layer so that recombination centers can be formed in the n-layer to cause a reduction in conversion efficiency. Thus, there has been a demand for alternative materials or fabrication methods with which the transparent electrode can be formed with no damage to the n-layer.

### BRIEF DESCRIPTION OF THE DRAWINGS

FIG. 1 is a schematic cross-sectional view of a thin-film photoelectric conversion element according to an embodiment;
FIG. 2 is a transmission electron microscope image of a cross-section of an embodiment;
FIG. 3 is an enlarged view of an oxide layer shown in Fig. 2, which is formed by spin coating;
FIG. 4 is a transmission electron microscope image of a cross-section of an embodiment;
FIG. 5 is an enlarged view of an oxide layer shown in Fig. 4, which is formed by spin coating;
FIG. 6 is an electron diffraction image of a site of an oxide layer 5A, which is formed by spin coating, shown in Fig. 2 where the site is indicated by *1;
FIG. 7 is an electron diffraction image of a site of an oxide particle layer 5B, which is formed by spin coating, shown in Fig. 4 where the site is indicated by *2; and
FIG. 8 is an electron diffraction image of a site of a transparent electrode layer 6, which is formed by sputtering, shown in Fig. 4 where the site is indicated by *1.

### DETAILED DESCRIPTION

A photoelectric conversion element of an embodiment includes: a p-type light absorbing layer having a chalcopyrite structure; an n-type semiconductor layer on the p-type light absorbing layer; an oxide layer on the n-type semiconductor layer; and a transparent electrode on the oxide layer.

Embodiments will be described below with reference to the drawings.

Hereinafter, embodiments will be described by way of example with reference to the drawings.

### (Photoelectric conversion element)

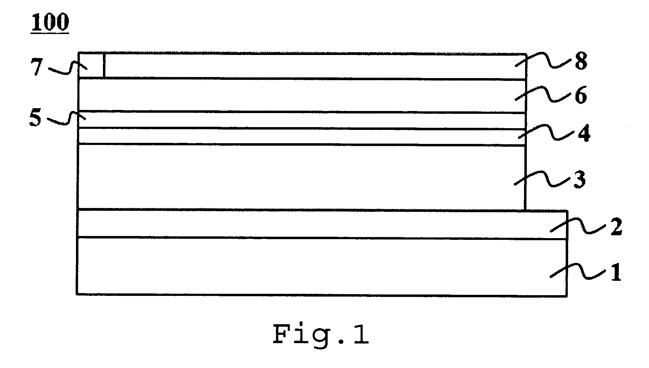

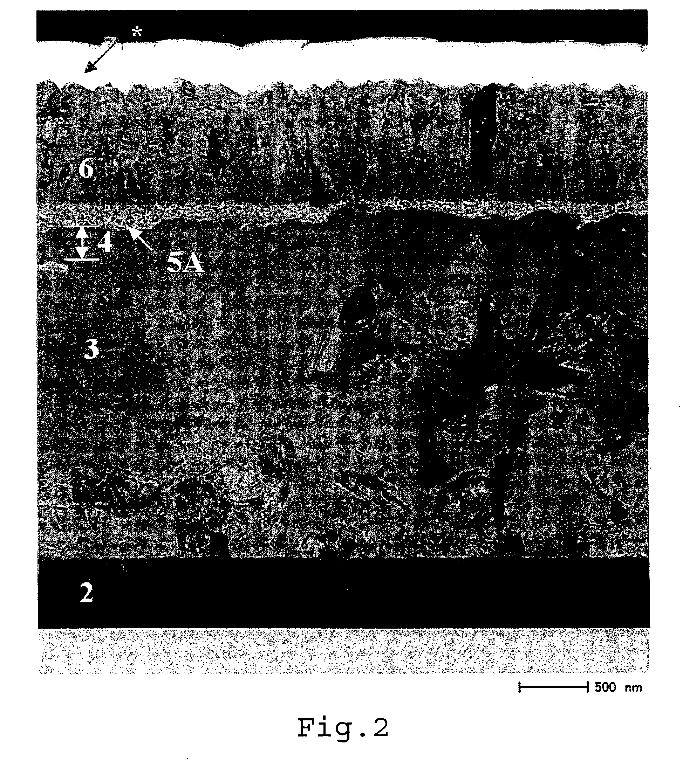

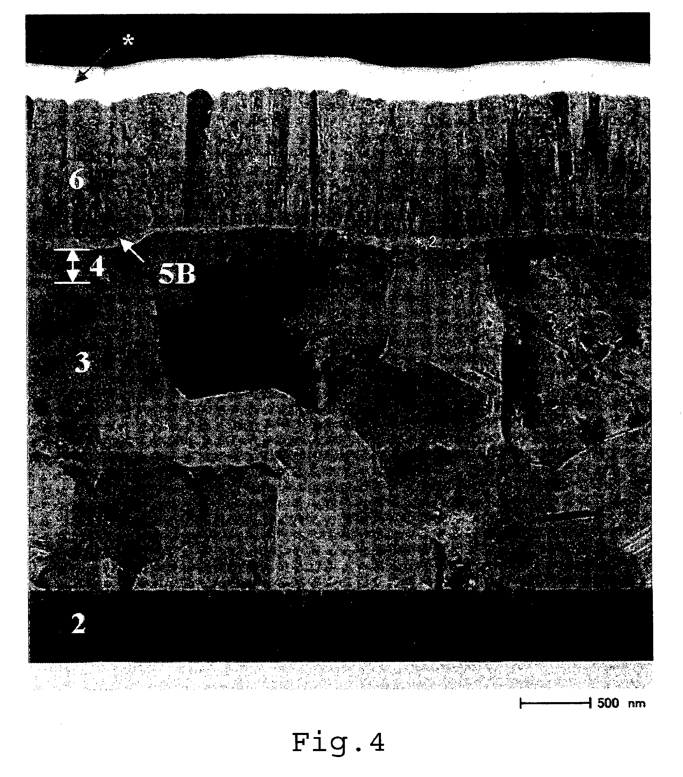

FIG. 1 is a schematic diagram showing a photoelectric conversion element 100 according to an embodiment. The photoelectric conversion element 100 is a thin-film photoelectric conversion element including a substrate 1, a lower electrode 2 formed on the substrate 1, a p-type light absorbing layer 3 formed on the lower electrode 2, an n-layer 4 formed on the p-type light absorbing layer 3, an oxide layer 5 formed on the n-layer 4, a transparent electrode 6 formed on the oxide layer 5, and an upper electrode 7 and an anti-reflection film 8 formed on the transparent electrode 6. A practical example of the photoelectric conversion element 100 may be a solar cell including a photoelectric transducer. FIGS. 2 and 4 are transmission electron microscope (TEM) images each showing a cross-section of a photoelectric conversion element of an embodiment. In FIGS. 2 and 4, * indicated layer is a layer of a glue used in taking the images. In the TEM image of FIG. 2, an oxide layer 5A is an oxide particle layer including a particulate oxide formed using an oxide dispersion. In the TEM image of FIG. 4, an oxide layer 5B includes oxide particles formed using an organometallic reagent.

### (Substrate)

In an embodiment, blue sheet glass is preferably used as the substrate 1, while a sheet of metal such as stainless steel, titanium (Ti), or chromium (Cr) or resin such as polyimide may also be used as the substrate 1.

### (Lower electrode)

In an embodiment, the lower electrode 2, which is an electrode of the photoelectric conversion element, is a metal film formed on the substrate 1. A film of electrically conductive metal such as Mo or W may be used as the lower electrode 2. In particular, a Mo film is preferably used as the lower electrode 2. The lower electrode 2 can be formed as a film by sputtering or other techniques on the substrate 1. The lower electrode 2 typically has a thickness of 500 nm to 1,000 nm.

### (p-type light absorbing layer)

In an embodiment, the p-type light absorbing layer 3 is a p-type compound semiconductor layer. The p-type light absorbing layer 3 is formed on the principal surface of the lower electrode 2 opposite to the substrate 1. A compound semiconductor layer with a chalcopyrite structure containing elements of groups Ib, IIIb, and VIb, such as a CIGS (Cu-In-Ga-Se) or CIT (Cu-In-Te) structure may be used as the p-type light absorbing layer 3. The p-type light absorbing layer 3 typically has a thickness of 1,000 nm to 3,000 nm. The group Ib element is preferably copper (Cu). The group IIIb element is preferably at least one element selected from the group consisting of Al, In, and Ga, and more preferably includes In. The group VIb element is preferably at least one element selected from the group consisting of O, S, Se, and Te, and more preferably includes Se. In is more preferably used as the group IIIb element because the use of In in combination with Ga makes it easy to adjust the band gap to the desired level.
Specifically, the light absorbing layer 3 may be made of a compound semiconductor such as Cu(In,Ga)(S,Se)₂, Cu(In,Ga)(Se,Te)₂, Cu(In,Ga)₃(Se,Te)₅, Cu(Al,Ga,In)Se₂, or Cu₂ZnSnS₄ with a desired composition ratio, and more specifically made of Cu(In,Ga)Se₂, CuInSe₂, CuInTe₂, CuGaSe₂, or CuIn₃Te₅ with a desired composition ratio. A compound composed of elements preferably exists between the lower electrode 2 and the light absorbing layer 3.

In an embodiment, the light absorbing layer 3 may be formed by a thin-film forming method such as sputtering, vapor deposition, or selenization/sulfurization process.

The vapor deposition is preferably performed in a high vacuum atmosphere at a substrate (a member composed of the substrate 1 and the lower electrode 2 formed thereon) temperature of 10°C to 600°C, more preferably 400°C to 560°C. If the temperature of the substrate 1 is too low, the formed p-type light absorbing layer 3 can have low crystallinity, and contrary if the temperature is too high, the light absorbing layer 3 can have too large crystal grains, which may cause a reduction in the conversion efficiency of the photoelectric conversion element. After the light absorbing layer 3 is formed, it may be annealed so that the crystal grain growth can be controlled.

### (n-type semiconductor layer)

In an embodiment, the n-layer 4 is an n-type semiconductor layer. The n-layer 4 is formed on the principal surface of the p-type light absorbing layer 3 opposite to the lower electrode 2. The n-layer 4 is preferably an n-type semiconductor whose Fermi level is controlled so that a photoelectric conversion element with a high open circuit voltage can be obtained. The n-layer 4 may be any one of a semiconductor layer formed on the p-type light absorbing layer 3 or a layer of a certain region formed by doping the p-type light absorbing layer 3 as an original part with a dopant to convert the p-type into the n-type. When a semiconductor layer is formed as the n-layer 4 on the p-type light absorbing layer 3, the semiconductor layer typically has a thickness of 10 nm to 60 nm. The n-layer 4 may be made of CdS, Zn(O,S,OH), Mg-doped ZnO, Zn(O,S) doped with at least one element selected from the group consisting of boron (B), Al, In, and Ga as dopants, ZnMgO doped with such element, or n-type GaP with a controlled carrier density. When the n-layer 4 is formed by doping a certain region of the p-type light absorbing layer 3 as an original part with a dopant to convert the p-type into the n-type, the thickness of the n-layer 4 is preferably 0 nm to 500 nm.

Examples of the forming method of the n-layer 4 other than the doping method include sputtering, vapor deposition, chemical vapor deposition (CVD), chemical bath deposition (CBD), coating, etc.

When the n-type semiconductor layer 4 is formed by CBD, the deposition is preferably performed at a temperature of 50°C to 90°C, more preferably 60°C to 80°C. If the substrate temperature is too low, the quality of the formed n-type semiconductor layer 4 or the film production rate will be low, and contrary if the temperature is too high, it will be difficult to control the thickness of the n-type semiconductor layer 4 as desired. The n-type semiconductor layer 4 is a dense crystalline layer.

The method of doping part of the p-type light absorbing layer 3 with a dopant to convert the p-type into the n-type may be an immersion method. The p-type light absorbing layer 3 on the substrate 1 (lower electrode 2) may be immersed in a solution containing cadmium (Cd) as an n-dopant, counter ions, and ammonia water or any other medium (for example, a cadmium sulfate solution) at 0°C to 90°C with stirring or immersing for several minutes to several tens of hours. After taken out of the solution, the treated member is preferably dried.

### (Oxide layer)

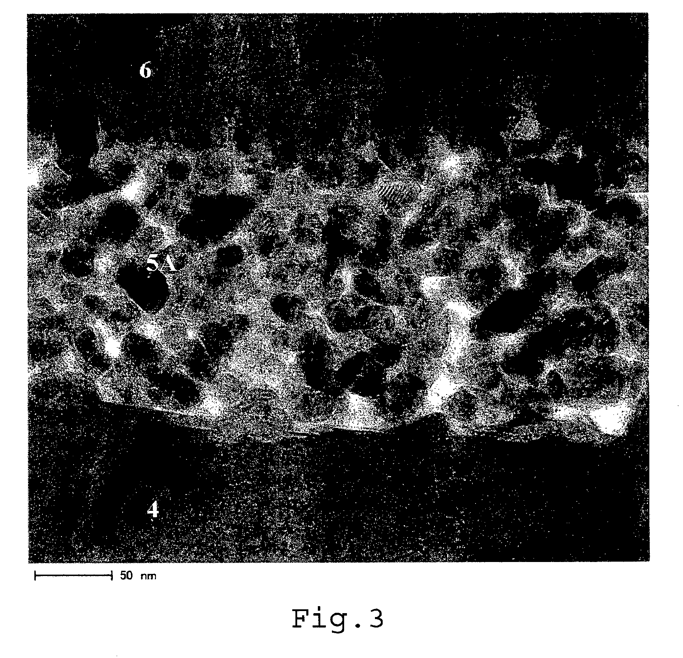

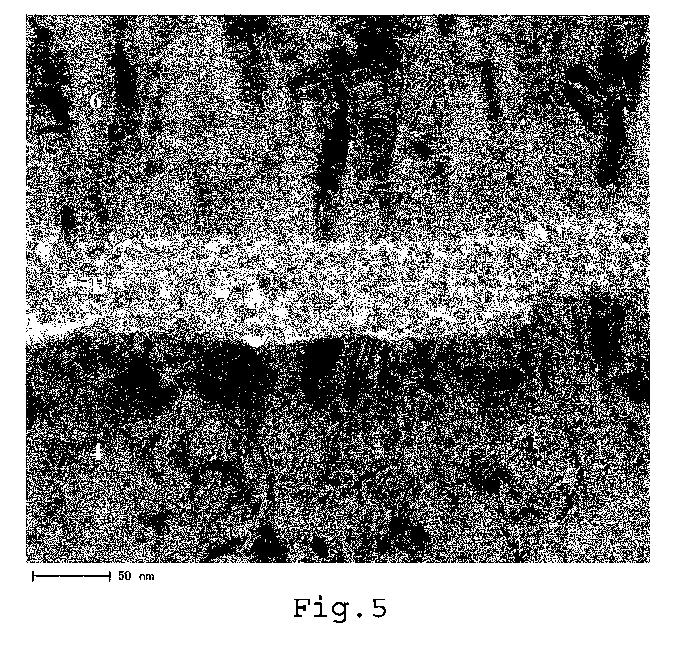

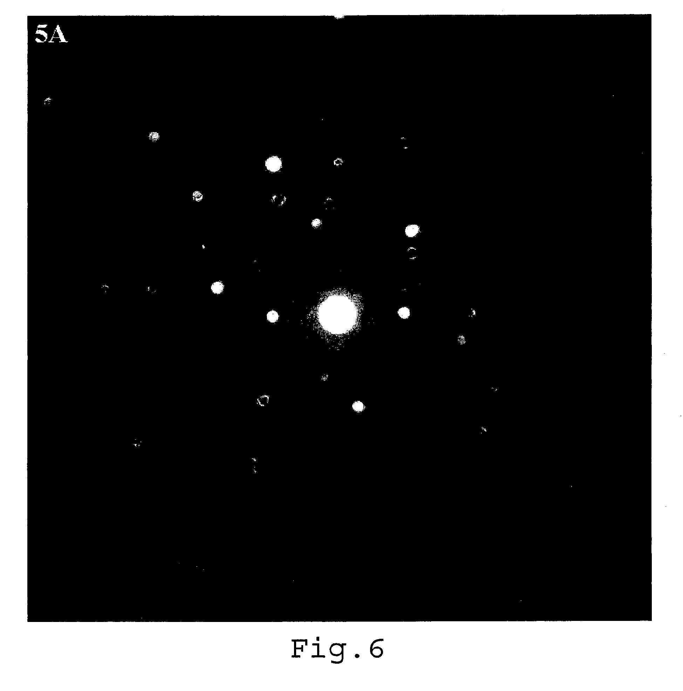

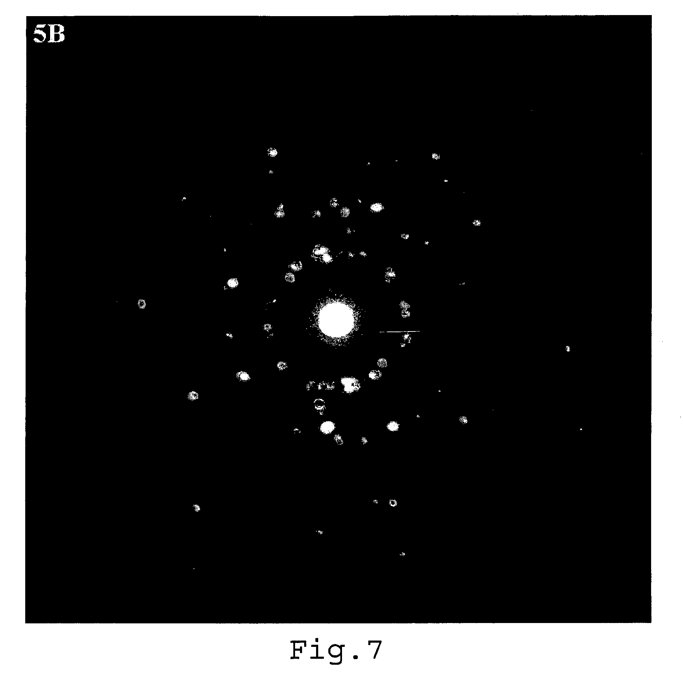

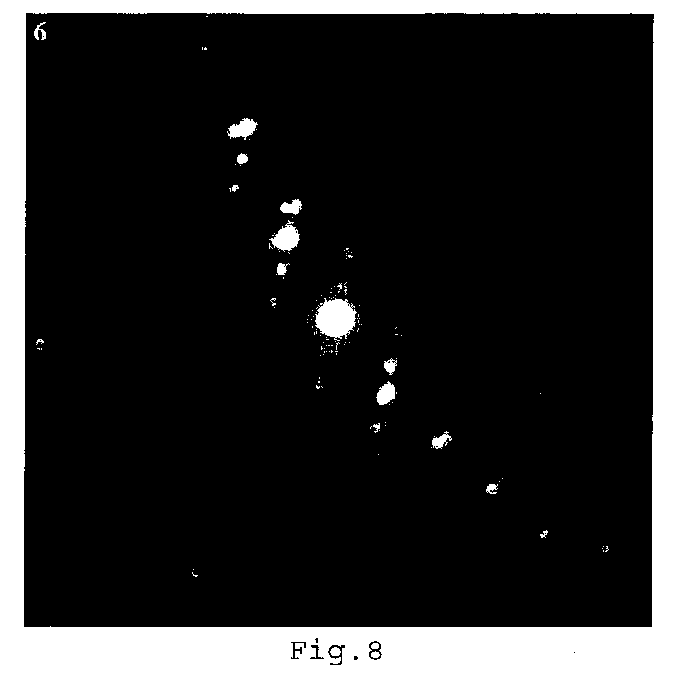

In an embodiment, the oxide layer 5 is formed on the principal surface of the n-layer 4 opposite to the light absorbing layer 3. FIGS. 3 and 5 are TEM images each showing an enlarged cross-section of a site including the oxide layer 5 of the photoelectric conversion element of an embodiment. In the TEM image of FIG. 3, the oxide layer 5A is the oxide particle layer of FIG. 2 containing a particulate oxide formed using an oxide dispersion. In the TEM image of FIG. 5, the oxide layer 5B is the oxide layer of FIG. 4 including oxide particles formed using an organometallic reagent. The oxide particle layer 5 is a low-density layer including particles. The oxide layer 5 and the transparent electrode 6 differ in crystallinity. It is apparent from the electron diffraction images of FIGS. 6, 7, and 8 that crystals in the oxide layers 5A and 5B are not oriented, whereas crystals in the transparent electrode 6 are oriented. It is apparent that crystals are discontinuous at the interface between the oxide layer 5 and the transparent electrode 6.

The oxide layer 5 preferably has a thickness of about 5 nm to about 200 nm. Its thickness may be smaller or larger than the preferred thickness as long as its thickness is such that damage can be reduced during the formation of the transparent electrode 6. However, an oxide layer which is too thick is not preferred because too large thickness may have an adverse effect on the conversion efficiency.

The oxide particle layer 5A includes particles of an oxide containing at least one element of zinc, titanium, indium, and magnesium. For example, particles of elements of an oxide containing zinc and magnesium may be represented by Zn₁₋ₓMgₓO (0<x<1). The oxide particles preferably have an average primary particle size of 1 nm to 40 nm. The oxide particle layer 5A is not dense and contains oxide particles and voids. The oxide particle layer 5A is a low-density layer because it contains voids and an organic component.

The oxide particle layer 5A, which is not formed by CVD or similar techniques, contains particles as mentioned above. The average primary particle size of zinc-containing oxide particles can be determined by dynamic light scattering analysis of a dispersion solution of the particles used for the preparation of the photoelectric conversion element 100 or by transmission electron microscope observation of the cross-section of a central part of the photoelectric conversion element. In the TEM observation, the sizes of all particles may be measured in an enlarged image of the oxide particle layer 5 observed at a magnification of about x300,000, and the measurements may be averaged. The oxide particle layer 5A contains particles, voids, and an organic component. For example, in the TEM image of FIG. 3 of the oxide particle layer 5A, therefore, bright and dark parts can be observed with relatively high contrast. The electron diffraction image of FIG. 6 also shows that the crystals are randomly oriented. It is conceivable that the voids can be formed due to the vaporization of a volatile organic compound in the solution used in the process of forming the oxide particle layer 5A and due to the presence of an organic component used as a coating in the process of dispersing zinc oxide into a solution.

On the other hand, the oxide particle layer 5B includes particles of an oxide containing at least one element of zinc, titanium, indium, and magnesium. For example, particles of an oxide containing zinc and magnesium may be represented by Zn₁₋ₓMgₓO (0<x<1). The TEM image of FIG. 5 shows that the region sandwiched between the n-layer 4 and the transparent electrode 6 has relatively small crystal grains, and the electron diffraction shows that such crystal grains are randomly oriented.

It will be described how to identify the oxide layer with crystallinity different from that of the transparent electrode layer. Two points on a straight line perpendicular to the lower electrode surface are observed in a cross-section observation (such as TEM) image clearly showing the structure of the photoelectric conversion element. One of the two points is located in the region of the oxide layer 5, and the other in the region of the transparent electrode 6. The two points do not always have to be on a straight line perpendicular to the lower electrode surface. As indicated by *1 and *2 in FIG. 4, the two points may be not on a straight line perpendicular to the lower electrode surface as long as each point has the typical characteristics of each layer. The oxide layer 5 located on the n-layer (CIGS) 4 is formed between the interface of CIGS and the interface of the transparent electrode. A diffraction image obtained at a middle point between these interfaces can show the difference in crystallinity from the transparent electrode. The crystallinity of the transparent electrode can be identified by the observation of a diffraction image at a middle point between its interface with the oxide layer and its surface.

If the oxide layer 5 is absent, the transparent electrode 6 will be formed on the n-layer 4 by sputtering, CVD, or vacuum deposition, so that recombination centers can be formed in the n-layer 4 due to plasma damage or chemical reaction to the n-layer 4. The oxide layer 5, which can be formed by spin coating, spraying, dipping, or other methods, serves as a protective layer for the n-layer 4 during the formation of the transparent electrode 6. In an embodiment, the oxide layer 5 can reduce or prevent the decrease in power generation efficiency caused by the formation of recombination centers.

The oxide layer 5 may be formed by a spin coating method. In this case, a dispersion solution in which particles of an oxide containing at least one element of zinc, titanium, indium, and magnesium are dispersed at a controlled concentration or a solution of an organometallic compound containing at least one element of zinc, titanium, indium, and magnesium is dropped on the principal surface of the n-layer 4 of the product obtained after the formation of the n-layer 4. The oxide particle layer 5A is formed using the dispersion solution in which oxide particles are dispersed. On the other hand, the oxide particle layer 5B is formed using the solution of the organometallic compound. After the dropping, a spin coater in contact with the principal surface of the n-layer 4 is rotated at a high speed to uniformly spread the dispersion solution on the n-layer 4. After the coating, the transparent electrode layer 6 is deposited. When spin coating or other coating techniques are used, a leveling effect can be produced so that the surface roughness can be effectively leveled off. In this case, therefore, the coating thickness may be uneven to a certain extent after the coating process.

A solvent in which the solute can be dispersed or dissolved is preferably used to form the solution to be dropped. If the solvent is less volatile, drying will be necessary as an additional step. Therefore, the solvent is preferably volatile and easy to handle. The solution for use in the spin coating can also be used in the dipping or spraying method described below.

For example, the dispersion medium for use in the dispersion solution may be a butanol solution containing an organic material. Examples of such an organic component include organic materials suitable for use in the medium for dispersing the oxide particles, such as polyethylene oxide, fatty acids, long-chain alkyl sulfates, long-chain monoalkyl phosphates, long-chain dialkyl phosphates, acyl amino acids, alkyl amino acids, amide derivatives, amine derivatives, guanidine derivatives, and alkyl betaines. Zinc oxide dispersion solutions manufactured or sold by SOLAR CO., LTD., Wako Pure Chemical Industries, Ltd., Kao Corporation, and Hakusuitech Co., Ltd. may also be used.

Examples of the organometallic compound that maybe used include compounds represented by M (-R) x, wherein R is an alkyl chain, M is a compound capable of forming the organic metal, such as zinc, titanium, indium, or magnesium, and x is from 1 to 4. Two or more organometallic compounds may be used. The organometallic compound can be oxidized into an oxide of the organic compound and the metal. The oxidation occurs when the solvent undergoes vaporization or other process so that the organometallic compound is allowed to react with oxygen in the air or in the solution. Specific examples of the organometallic compound include compounds represented by M (-R) x, wherein R is methyl, ethyl, propyl, butyl, or cyclopentane. A suitable additive may be added to the solution to stabilize the solution or accelerate the oxidation of the organometallic compound.

A common organic solvent such as toluene, hexane, or 1,2-diethoxyethane may be used to form a solution of the organometallic compound.

The oxide layer 5 may be formed by a dipping method. In this case, the product obtained after the formation of the n-layer 4 is immersed in the oxide dispersion with its concentration adjusted in advance or the solution containing the organometallic compound, and pulled out, so that a coating is uniformly formed. The coating thickness depends on the concentration of the dispersion and the pulling speed. Therefore, the conditions should be examined in advance so that a coating thickness of 5 nm to 200 nm can be obtained. The thickness may be relatively large or small as long as the thickness is such that damage can be reduced during the formation of the transparent electrode 6.

The oxide layer 5 may be formed by a spray method. In this case, the solution containing the oxide or the organometallic compound at a concentration adjusted in advance is sprayed on the product obtained after the formation of the n-layer 4. The coating thickness depends on the amount of spray. Therefore, the conditions should be examined in advance so that a coating thickness of 5 nm to 200 nm can be obtained. The thickness may be relatively large or small as long as the thickness is such that damage can be reduced during the formation of the transparent electrode 6.

The oxide layer 5 prepared by the process described above contains an organic material derived from the residual part of the dispersion or the organometallic compound. The presence or absence of the organic material and the type of the organic material can be identified by a method that includes scraping substantially the whole of the oxide layer 5 off the photoelectric conversion element, extracting organic components with a suitable solvent, and subjecting the extract to infrared absorption analysis, mass spectrometry, nuclear magnetic resonance, or other processes.

### (Transparent electrode)

In an embodiment, the transparent electrode 6 is a film electrically conductive and transparent for light such as sunlight. For example, the transparent electrode 6 can be formed using ZnO : Al containing 2 wt% of alumina (Al₂O₃) or using ZnO : B containing B as a dopant derived from diborane. The transparent electrode is an oriented, dense, highly-crystalline layer, which is formed by vapor deposition, sputtering, or other techniques.

### (Upper electrode)

In an embodiment, the upper electrode 7, which is an electrode of the photoelectric conversion element, is a metal film formed on the transparent electrode 6. A film of electrically conductive metal such as Al or Ni can be used as the upper electrode 7. The upper electrode 7 typically has a thickness of 100 nm to 2,000 nm.

### (Anti-reflection film)

In an embodiment, the anti-reflection film 8 is a film provided to facilitate the introduction of light into the p-type light absorbing layer 3. The anti-reflection film 8 is formed on the transparent electrode 6. For example, the anti-reflection film 8 is preferably made of MgF₂.

Hereinafter, the present disclosure will be more specifically described with reference to examples.

### (Example 1)

A film-shaped lower electrode of simple Mo was formed on a blue sheet glass of 22 mm in length, 12.5 mm in width, and 1.8 mm in thickness by sputtering in an Ar gas flow. The lower electrode had a thickness of about 500 nm. A film composed of Cu, In, Ga, and Se in a desired ratio was formed by vapor deposition on the Mo lower electrode on the blue sheet glass substrate. The film had a thickness of about 2,200 nm. A CdS layer with a thickness of about 50 nm was then formed as an n-type semiconductor layer on the film by CBD method, and an oxide particle layer 5 with a thickness of about 50 nm was formed on the CdS layer by spin coating. The spin coating was performed using zinc oxide, an oxide containing zinc, which had particle sizes of 25. 6 nm, 31.5 nm, and 54. 5 nm at cumulative frequencies of 10%, 50%, and 90%, respectively. After the oxide particle layer 5 was formed, a ZnO : Al layer with a thickness of about 1,000 nm was formed as a transparent electrode on the particle layer. An Al film with a thickness of about 220 nm was formed as an upper electrode on the transparent electrode. As a result, a photoelectric conversion element of an embodiment was obtained.

### (Example 2)

A film-shaped lower electrode of simple Mo was formed on a blue sheet glass substrate 22 mm in length, 12.5 mm in width, and 1.8 mm in thickness by sputtering in an Ar gas flow. The lower electrode had a thickness of about 500 nm. A film composed of Cu, In, Ga, and Se in a desired ratio was formed by vapor deposition on the Mo lower electrode on the blue sheet glass substrate. The film had a thickness of about 2,000 nm. The resulting film was doped with Cd as an n-dopant by an immersion method to form an n-type semiconductor layer, n-CIGS. The doping with Cd was performed using an ammonia solution of cadmium sulfate while the solution was stirred at 80°C for 22 hours. After the doping, the doped product was washed with water and dried. After this process, a photoelectric conversion element was prepared as in Example 1.

### (Example 3)

The same process as in Example 2 was used to form the components until the n-layer was formed. Under a nitrogen atmosphere, a solution formed by mixing THF and water in a ratio of 1 : 1 was added to a solution formed by mixing diethylzinc and 1,2-diethoxyethane in a volume ratio of 1 : 9 in such a manner that zinc and water were mixed in a molar ratio of 1 : 0.6. In a nitrogen atmosphere, the resulting solution was dropped on the sample obtained after the formation of the n-layer, and uniformly spread by spin coating at 6, 000 rpm. The coating was dried by heating at 100°C for 5 minutes under nitrogen to form an oxide particle layer with a thickness of 37 nm. A transparent electrode was formed on the product by sputtering so that a photoelectric conversion element was obtained.

### (Example 4)

The same process as in Example 2 was used to form the components until the n-layer was formed. Under a nitrogen atmosphere, a solution formed by mixing THF and water in a ratio of 1 : 1 was added to a solution formed by mixing diethylzinc and 1,2-diethoxyethane in a volume ratio of 0.5 : 9 in such a manner that zinc and water were mixed in a molar ratio of 1 : 0.6, and magnesium nitrate was added to this solution were mixed in a molar ratio of Zinc : Magnesium are 1 : 0.05. In a nitrogen atmosphere, the resulting solution was dropped on the sample obtained after the formation of the n-layer, and uniformly spread by spin coating at 4,000 rpm. The coating was dried by heating at 100°C for 5 minutes under nitrogen to form an oxide particle layer with a thickness of 28 nm. A transparent electrode was formed on the product by sputtering so that a photoelectric conversion element was obtained.

### (Comparative Example 1)

A photoelectric conversion element was prepared as in Example 1, except that the oxide layer 5 was not formed.

### (Comparative Example 2)

A photoelectric conversion element was prepared as in Example 2, except that the oxide layer 5 was not formed.

The conversion efficiency of the photoelectric conversion elements of the examples and the comparative examples was determined.

The conversion efficiency (η = Voc·Js·FF/P·100 [%]) of each photoelectric conversion element is shown in the table below.

Table 1

| Conversion efficiency [%] | |
|---|---|
| | Conversion efficiency [%] |
| Example 1 | 16.2 |
| Example 2 | 12.2 |
| Example 3 | 16.9 |
| Example 4 | 17.8 |
| Comparative Example 1 | 14.3 |
| Comparative Example 2 | 2.7 |

A comparison between the conversion efficiencies (averages) of the photoelectric conversion elements with and without the oxide layer showed that all those with the oxide layer had higher conversion efficiency. This is because when the oxide layer according to the embodiment is not provided, the process of forming the transparent electrode by sputtering can significantly damage the n-layer so that the conversion efficiency can decrease. It is apparent from the examples that the formation of the oxide layer according to the embodiment is effective in reducing (preventing) damage to the n-layer. The efficiency improvement is particularly significant for the homo-junction cell. This is because CdS can have a certain degree of protective function in the hetero-junction solar cell. Thus, the effect of forming the oxide layer according to the embodiment is more significant for homo-junction solar cells. It will be understood that even when the oxide and other materials used in the examples are replaced by any of the materials described above or materials with different physical properties such as different particle sizes, the oxide layer can be effective as in the examples.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A photoelectric conversion element, comprising:
a p-type light absorbing layer having a chalcopyrite structure;
an n-type semiconductor layer on the p-type light absorbing layer;
an oxide layer on the n-type semiconductor layer; and
a transparent electrode on the oxide layer.

2. The element according to claim 1, wherein the oxide layer and the transparent electrode differ in crystallinity and form an interface at which crystals are discontinuous.

3. The element according to claim 1, wherein the oxide layer contains an organic material.

4. The element according to claim 1, wherein
the oxide layer contains oxide particles with an average primary particle size of 1 nm to 40 nm, and
the oxide particles contains at least one element of zinc, titanium, indium, and magnesium.

5. The element according claim 1, wherein the n-type semiconductor layer is a layer formed by converting the p-type light absorbing layer into an n-type layer.

6. A solar cell, comprising a photoelectric conversion element comprising:
a p-type light absorbing layer having a chalcopyrite structure;
an n-type semiconductor layer on the p-type light absorbing layer;
an oxide layer on the n-type semiconductor layer; and
a transparent electrode on the oxide layer.

7. The cell according to claim 6, wherein the oxide layer and the transparent electrode differ in crystallinity and form an interface at which crystals are discontinuous.

8. The cell according to claim 6, wherein the oxide layer contains an organic material.

9. The cell according to claim 6, wherein
the oxide layer contains oxide particles with an average primary particle size of 1 nm to 40 nm, and
the oxide particles contains at least one element of zinc, titanium, indium, and magnesium.

10. The cell according claim 6, wherein the n-type semiconductor layer is a layer formed by converting the p-type light absorbing layer into an n-type layer.
